# FASCICULE DE BREVET EUROPEEN

(11) **EP 0 357 528 B1**
(45) Date de publication et mention de la délivrance du brevet: **10.03.1993**
(21) Numéro de dépôt: 89420316.5
(22) Date de dépôt: 28.08.1989
(51) Int. Cl.: H01L 27/02, H03K 17/08

(54) **Transistor MOS composite et application à une diode roue libre**
MOS-Transistor und Anwendung bei einer Freilaufdiode
MOS transistor and its use in a free running diode

(30) Priorité: 31.08.1988 FR 8811659
(43) Date de publication de la demande: 07.03.1990
(73) Titulaire: SGS-THOMSON MICROELECTRONICS S.A., 94250 Gentilly (FR)
(72) Inventeur: Nadd, Bruno, F-84160 Lourmarin Par Cadenet (FR)
(74) Mandataire: de Beaumont, Michel

(56) Documents cités:
- EP-A- 0 107 137
- ELEKTRONIK, vol. 37, no. 2, 22 janvier 1988, pages 86-87, Munich, DE; "Abschied von externen Dioden"

## Description

La présente invention concerne le domaine des semi-conducteurs et plus particulièrement des transistors MOS. Elle trouve des applications notamment dans le domaine des transistors MOS de puissance.

Plus particulièrement, la présente invention vise un transistor MOS composite tel que son substrat est automatiquement connecté au potentiel le plus bas parmi les potentiels appliqués à ses deux électrodes principales (source et drain).

D'autre part, la présente invention vise une application du composant selon l'invention à une structure de diode roue libre, du type diode active, pouvant être fabriquée monolithiquement dans une pastille de circuit comprenant également un transistor MOS de puissance du type transistor MOS vertical diffusé (VDMOS), ou équivalent.

Avant de décrire la présente invention, on rappelera les problèmes qui se posent pour la réalisation d'une diode roue libre dans des technologies du type incluant des transistors MOS verticaux diffusés et des transistors MOS logiques latéraux sur une même puce de circuit intégré.

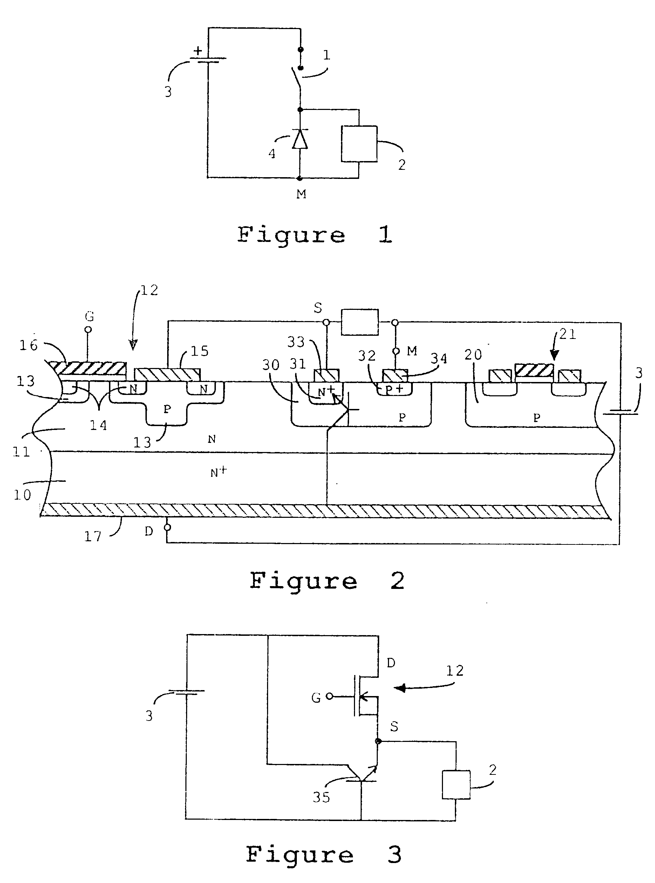

Tout d'abord, la figure 1 représente la connexion d'un commutateur de puissance 1 et d'une charge 2 aux bornes d'une source d'alimentation continue 3. De façon classique, dans le cas où la charge 2 est une charge inductive, on dispose en série avec le commutateur de puissance et en parallèle sur la charge une diode 4, dite diode de roue libre, destinée à continuer à laisser circuler le courant inductif de la charge quand le commutateur s'ouvre, cette diode étant polarisée en inverse par rapport au sens de passage du courant quand le commutateur principal 1 est fermé. La diode roue libre a pour effet d'éviter les surtensions importantes qui se produiraient en son absence quand le commutateur principal 1 en série avec la charge s'ouvre brutalement.

Les utilisateurs de commutateurs de puissance souhaitent généralement que cette diode de roue libre 4 soit intégrée dans la même pastille semiconductrice que le commutateur de puissance.

La figure 2 représente en coupe et de façon très schématique la réalisation d'une telle diode roue libre intégrée dans une technologie comprenant sur une même puce des transistors MOS diffusés de puissance et des transistors formant un circuit de commande.

Comme le représente la figure 2, cette technologie utilise un substrat comprenant une couche inférieure 10 de type N+ et une couche 11 de type N. Dans la couche 11 de type N sont formées de très nombreuses cellules de transistor MOS de puissance dont l'une est représentée schématiquement et désignée par la référence 12. Chaque cellule de transistor de puissance comprend des zones de diffusion P 13 dans lesquelles sont diffusées des zones N 14. Une métallisation de source 15 contacte les zones 14 et la zone P 13 qui les sépare. Une métallisation (silicium polycristallin) de grille isolée 16 permet d'ouvrir des canaux dans les parties latérales des zones P de sorte qu'il s'établit une conduction entre l'électrode de source 15 et une métallisation de drain 17 formée sur la face arrière du composant.

On trouve également dans cette structure un ou plusieurs caissons 20 de type P dans lesquels sont formés des transistors MOS 21 permettant de réaliser un circuit de commande.

Un procédé classique pour réaliser de façon monolithique la diode de roue libre consiste à effectuer dans un caisson 30 de type P, analogue aux caissons 20 contenant les circuits de commande, une diffusion N+ 31 et un contact P+ 32 dont sont solidaires des métallisations 33 et 34, respectivement. La métallisation 33 est reliée à la métallisation de source 15 et à la première borne de la charge et la métallisation 34 est reliée à l'autre borne de la charge et à la borne négative de la source d'alimentation 3 dont la borne positive est reliée au drain D.

Le schéma équivalent du circuit de la figure 2 est illustré en figure 3 dans laquelle on retrouve la charge 2, la source d'alimentation 3 et le transistor de puissance 12. La jonction N+P entre les zones 31 et 32 correspond à la jonction émetteur-base d'un transistor bipolaire parasite 35 de type NPN dont le collecteur correspond aux couches 11 et 10 de la figure 2 et est connecté par conséquent au drain D du transistor de puissance 12. Il en résulte, lors du fonctionnement de la diode de roue libre, une dissipation de puissance importante dans ce transistor parasite 35 et des courants parasites qui peuvent perturber les circuits de commande. Les procédés classiques pour réduire le gain de ce transistor bipolaire parasite sont insuffisants en raison du courant élevé qui peut circuler dans la charge.

Pour pallier cet inconvénient, on a imaginé dans l'art antérieur de réaliser des structures du type "diode active" c'est-à-dire des structures commandées, sélectivement passantes ou bloquées selon la polarité de la tension à leurs bornes.

Une telle structure de diode active est illustrée en figure 4. Elle comprend les mêmes éléments désignés par les mêmes références que ceux de la figure 3 avec l'adjonction d'un transistor MOS 40 commandé en opposition de phase par rapport au transistor de puissance 12 et en parallèle sur la charge 2. Ainsi, ce transistor 40 est bloqué quand le transistor 12 est passant, et passant quand le transistor 12 est bloqué.

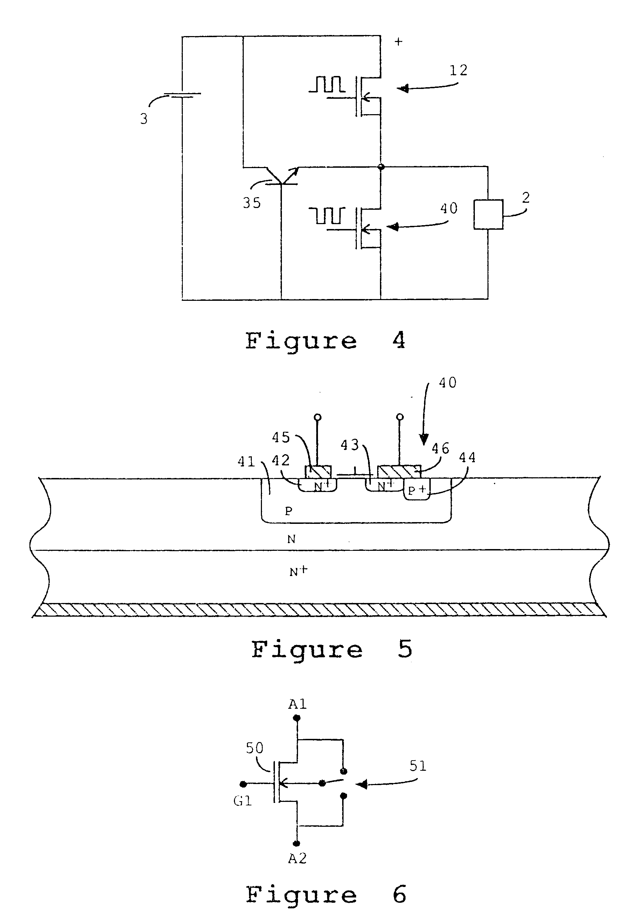

Cette solution semble a priori satisfaisante mais, dans des structures du type de celle décrite précédemment, il demeure un transistor bipolaire parasite 35. En effet, le transistor 40 est par exemple réalisé de la façon illustrée en figure 5 = il est formé dans un caisson 41 analogue au caisson 30 de la figure 2 et comprend une zone de drain 42 et une zone de source 43 reliée par une métallisation à une zone surdopée 44 de type P+ établissant un contact avec le caisson 41. Une grille est prévue entre les zones de drain et de source. La charge 2 sera reliée entre les métallisations de drain 45 et de source 46. De même qu'en figure 2, la métallisation de drain 45 sera reliée à la source 15 du transistor de puissance. Toutefois, comme cela est représenté en figure 4, on retrouve le transistor parasite 35 dont l'émetteur correspond à la région 42, la base au caisson 41 et le collecteur au drain du transistor de puissance. Normalement, ce transistor bipolaire parasite est inactif quand le transistor MOS 40 est passant (lors du fonctionnement en roue libre). Toutefois, pour qu'il reste bloqué, il est nécessaire que la chute de tension aux bornes du transistor 40 soit inférieure à la chute de tension émetteur/base d'un transistor bipolaire, c'est-à-dire environ 0,7 volt. Ceci impose que la résistance à l'état passant du transistor MOS 40 soit faible et donc que sa surface soit importante, ce que l'on cherche à éviter lors de la réalisation d'un composant.

Ainsi, les deux solutions de l'art antérieur, représentées respectivement en figures 2 et 5, entraînent l'apparition d'un transistor bipolaire parasite dont les effets sont néfastes sauf, dans le cas des figures 4 et 5, si on accepte de sacrifier une surface de silicium importante.

En outre, dans les deux cas de l'art antérieur ci-dessus, lors du fonctionnement en roue libre, il n'est pas possible d'amortir rapidement le courant, celui-ci étant limité seulement par la résistance interne de la charge qui est souvent très faible. En effet, même dans le cas des figures 4 et 5, si on augmentait la résistance du transistor MOS 40, on entraînerait la mise en conduction de la diode base/émetteur du transistor bipolaire 35, et donc la commutation de ce transistor à l'état passant.

Enfin, un autre inconvénient de ces dispositions de l'art antérieur est que, dans le cas où il se produirait accidentellement une inversion de polarité de la source d'alimentation, ce qui est un risque non-négligeable par exemple dans le cas d'un circuit connecté à une batterie d'automobile, rien ne limite le courant qui peut s'écouler à travers la diode de roue libre et à travers la diode existant de façon inhérente en parallèle sur le transistor de puissance 12 (diode constituée entre la métallisation de drain 17 et la métallisation de source 15 qui est également en contact avec la région 13 de type P (voir figure 2)).

La présente invention propose un transistor MOS composite à commutation de connexion de substrat.

Ce transistor MOS composite réalisé dans un substrat d'un premier type de conductivité comprend une électrode de grille, une première électrode principale, une deuxième électrode principale et une zone de substrat, ainsi que des moyens pour connecter à la zone de substrat celle des première et deuxième électrodes principales qui est au plus faible potentiel.

Dans un mode de réalisation de l'invention, les première et deuxième électrodes principales sont respectivement connectées à une première borne principale d'un premier et d'un deuxième transistor MOS auxiliaire dont les deuxièmes bornes principales sont reliées au substrat ; les grilles des premier et deuxième transistors auxiliaires sont commandées de façon complémentaire par la sortie d'un comparateur de tension dont les entrées sont connectées aux électrodes principales dudit transistor composite ; d'où il résulte que l'électrode principale dudit transistor composite qui est au potentiel le plus faible est automatiquement reliée au substrat.

Ce transistor peut trouver de nombreuses applications qui apparaîtront à l'homme de l'art. L'une de ces applications est son utilisation comme diode active en remplacement du transistor MOS 40 décrit en relation avec les figures 4 et 5. On évite alors les trois inconvénients présentés ci-dessus des dispositifs de l'art antérieur.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1 à 5, destinées à illustrer l'état de la technique, ont été décrites précédemment ;
la figure 6 représente sous forme de schéma de circuit un aspect général du transistor MOS composite selon la présente invention ;
les figures 7A et 7B sont des schémas de circuit plus détaillés représentant un transistor MOS composite selon la présente invention ;
la figure 8 représente une vue en coupe de tranche semi-conductrice illustrant un mode de réalisation schématique d'un transistor MOS composite selon la présente invention ;
les figures 9 et 10 représentent des vues en coupe équivalentes et simplifiées correspondant à la vue en coupe de la figure 8 selon la polarisation appliquée au transistor MOS composite selon la présente invention ; et
les figures 11 et 12 sont des schémas de circuit représentant l'utilisation d'un transistor MOS composite selon l'invention dans une application à une diode roue libre.

De façon générale, comme cela est classique dans le domaine de la représentation des circuits intégrés, on notera que les diverses vues en coupe ne sont pas représentées à l'échelle ni d'une figure à l'autre, ni à l'intérieur d'une même figure, et notamment que les épaisseurs des couches sont dessinées arbitrairement dans le but de faciliter la lecture des figures.

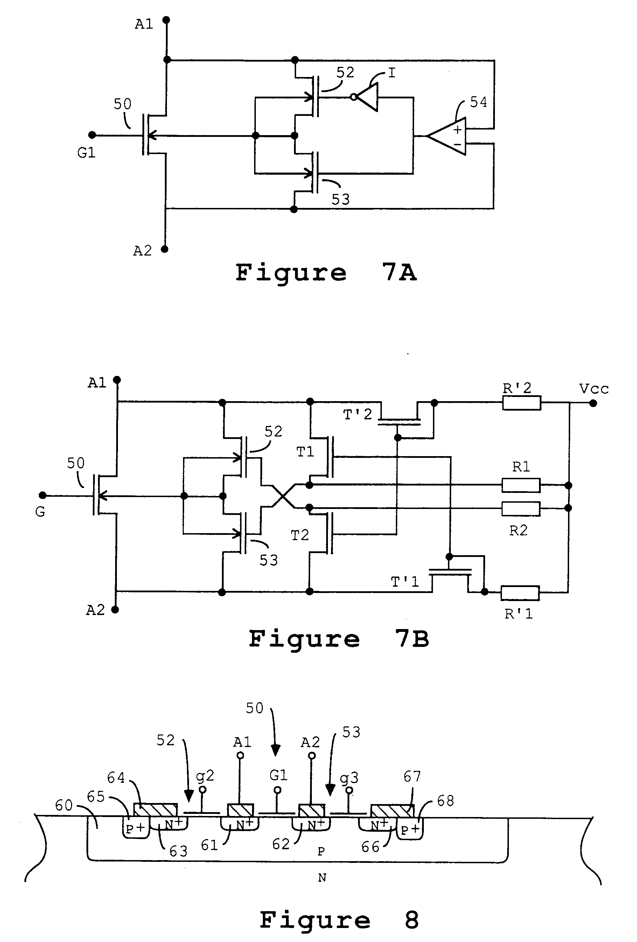

Comme le représente la figure 6, la présente invention concerne un transistor MOS composite comprenant des bornes principales A1 et A2 (qui auront alternativement une fonction de source et une fonction de drain) et une grille G1. Ce transistor MOS composite comprend un transistor MOS principal 50 et des moyens de commutation 51 pour relier son substrat (c'est-à-dire la couche dans laquelle sont formés sa source et son drain et dans une partie de laquelle se forme sous l'influence de la grille une région de canal) à l'une ou l'autre de ses bornes A1 et A2 et, plus précisément, à celle de ces bornes qui est au plus faible potentiel.

La figure 7A représente un mode de réalisation du dispositif de commutation 51. La borne de substrat du transistor MOS principal 50 est connectée aux bornes de substrat et aux premières bornes principales de transistors MOS auxiliaires 52 et 53 dont les autres bornes principales sont respectivement connectées aux bornes A1 et A2. Les grilles des transistors auxiliaires 52 et 53 sont commandées par la sortie d'un comparateur 54, directement en ce qui concerne le transistor MOS 53, et par l'intermédiaire d'un inverseur I en ce qui concerne le transistor 52. Le comparateur 54 compare les tensions aux bornes A1 et A2. Ainsi, de façon automatique, la borne de substrat du transistor 50 est connectée à celle de ses bornes A1 et A2 qui est au plus faible potentiel.

La figure 7B représente un exemple de réalisation de l'ensemble inverseur et comparateur représenté sous forme de blocs en figure 7A. On retrouve dans cette figure 7B le transistor principal 50 et les transistors auxiliaires 52 et 53. La grille du transistor 52 est reliée au drain d'un transistor T2 dont la source est reliée à la borne A2. De même, la grille du transistor 53 est reliée au drain d'un transistor T1 dont la source est reliée à la borne A1. Par ailleurs, la grille du transistor T2 est reliée à la grille d'un transistor T'2 dont la source est reliée à la borne A1 et le drain à sa grille et à la borne d'alimentation Vcc (par exemple 10 volts) par l'intermédiaire d'une résistance R'2. De même, la grille du transistor T1 est reliée à la grille d'un transistor T'1 dont la source est reliée à la borne A2 et le drain à sa grille et à la borne Vcc par l'intermédiaire d'une résistance R'1. Enfin, les bornes de grille du transistor 52 et de drain du transistor T2 sont reliées à la borne Vcc par l'intermédiaire d'une résistance R2 et la borne commune de grille du transistor 53 et de drain du transistor T1 est reliée à la borne Vcc par l'intermédiaire d'une résistance R1. Tous les transistors T1, T'1, T2, T'2, 52, 53 et 50 ont le même substrat.

Le fonctionnement de ce circuit est le suivant.

La résistance R'1 injecte un courant (Vcc - VT)/R'1 dans le transistor T'1. La tension sur le drain du transistor T'1 se polarise donc à +VT (tension de seuil d'un transistor MOS). La tension sur la grille du transistor T1 est donc également polarisée à +VT.

Si la tension sur la borne A1 est positive par rapport à la tension sur la borne A2, la source du transistor T1 est donc positive. La tension grille/source du transistor T1 est donc inférieure à VT et ce transistor T1 est bloqué. La grille du transistor 53 est donc connectée à la borne Vcc par l'intermédiaire de la résistance R1 ce qui a pour effet de faire conduire ce transistor 53. La résistance R'2 injecte un courant (Vcc - VT)/R'2 dans le transistor T'2 dont la grille se polarise à une tension de seuil VT au-dessus de la borne A1 qui est positive par rapport à la borne A2 ; la tension grille/source du transistor T2 est alors supérieure à VT ; donc le transistor T2 conduit et le transistor 52 se bloque. Il en résulte que le substrat du transistor 50 est relié à la borne A2, ce qui est l'effet recherché.

Si la tension sur la borne A1 est inférieure à la tension sur la borne A2, la source du transistor T1 est négative. La tension grille/source de ce transistor T1 est donc supérieure à une tension de seuil de transistor MOS (VT) et ce transistor T1 conduit. La grille du transistor 53 est donc connectée à la borne A1 par l'intermédiaire du transistor T1 et ce transistor est bloqué. Le substrat du transistor 50 n'est donc plus connecté à la masse mais à la borne A1 puisque dans ce cas c'est le transistor 52 qui conduit, ce qui est l'effet recherché.

La figure 8 représente une vue en coupe schématique d'un exemple de réalisation de la structure représentée sous forme de schéma de circuit en figure 7A. Cette vue en coupe représente un caisson P 60 constituant le substrat du transistor MOS 50. De façon classique, ce transistor 50 comprend dans le caisson 60 deux régions de type N 61 et 62 correspondant aux électrodes A1 et A2 qui peuvent être mises en relation de conduction sous l'effet d'une grille G1. La première région principale 61 constitue aussi la première région principale du premier transistor auxiliaire 52 dont la deuxième région principale 63 est reliée par une métallisation 64 à une zone surdopée 65 de type P réalisant un court-circuit avec le substrat. De même, le deuxième transistor auxiliaire 53 a sa première région principale correspondant à la diffusion 62 et sa deuxième région principale 66 est connectée par une métallisation 67 à un contact de substrat 68.

Les grilles g1 et g2 des transistors MOS auxiliaires 52 et 53 sont connectées à des éléments inverseur et amplificateur tels qu'illustrés en figure 7B et qui peuvent être réalisés dans le même caisson 60 que le reste de la structure.

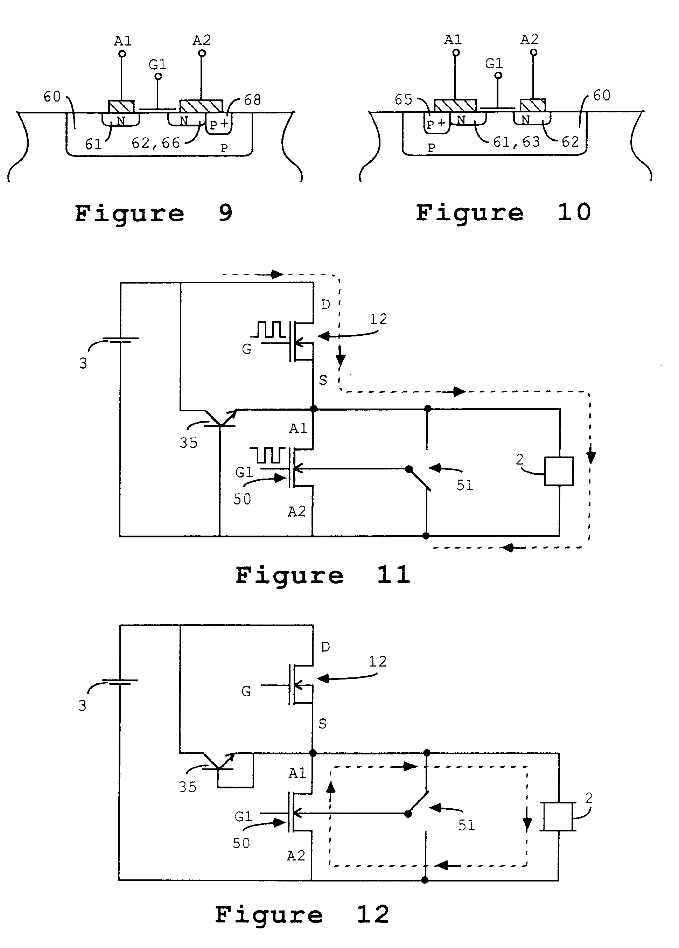

Ainsi, quand le potentiel sur la borne A1 est supérieur au potentiel sur la borne A2, la vue en coupe illustrée en figure 8 devient équivalente à celle représentée en figure 9 étant donné que la grille g3 agit pour établir une conduction entre les zones 62 et 66 tandis que les zones 61 et 63 sont isolées. Dans cette configuration, c'est la borne A2 qui est reliée au potentiel du caisson (substrat).

La figure 10 représente le cas inverse où le potentiel sur la borne A1 est inférieur au potentiel A2, c'est alors la borne A1 qui est au potentiel du caisson.

Les figures 11 et 12 représentent une application du transistor composite selon la présente invention en tant que diode roue libre active remplaçant le transistor MOS 40 utilisé comme diode roue libre active en figure 4. Les composants communs aux figures 11 et 12 sont désignés par les mêmes références.

La figure 11 représente le cas où le transistor MOS de puissance 12 est passant et où le transistor MOS 50 est bloqué. Dans ce cas, comme le montrent les traits en pointillés, le courant circule de l'alimentation à travers le transistor MOS de puissance 12 dans la charge 2. Le potentiel sur la borne A1 est plus élevé que le potentiel sur la borne A2, c'est donc la borne A2 qui est reliée au substrat (caisson). Dans cette configuration, comme dans le cas de la figure 4, il existe un transistor parasite 35. L'émetteur du transistor parasite correspond à la région 61 (borne A1), sa base au caisson 60 et son collecteur au drain du transistor de puissance. A ce stade du fonctionnement, comme dans le cas des figures 4 et 5, ce transistor 35 n'a aucun effet néfaste car sa jonction base/émetteur est polarisée en inverse.

La figure 12 représente la structure dans le cas où le transistor de puissance 12 est bloqué et où le transistor 51 est passant. Dans ce cas, le potentiel sur la borne A1 est plus faible que le potentiel sur la borne A2. C'est donc la borne A1 qui est reliée au substrat 60 du transistor 50 (voir figure 10). En conséquence, le transistor parasite 35 a son émetteur connecté à sa base, c'est-à-dire qu'il ne présente plus d'effet transistor et qu'il est équivalent à une simple diode passante de la borne A1 vers la borne positive de l'alimentation, c'est-à-dire une diode en parallèle sur la diode inverse normale du transistor de puissance.

Grâce à l'invention, même si la chute de potentiel aux bornes du transistor MOS 50 est non-négligeable, il ne peut se produire d'effets parasites. Ceci peut constituer un avantage car il est alors possible de faire décroître rapidement le courant de roue libre en augmentant la résistance du transistor 51 par action sur sa grille ou en plaçant en série avec le transistor une résistance, ce qui n'aurait pas été possible dans le cas des configurations illustrées en figures 3 et 5 car alors le transistor bipolaire parasite 35 serait devenu passant et aurait perturbé le fonctionnement du système. On peut ainsi utiliser un transistor 50 de très petite surface ayant une valeur de résistance à l'état passant relativement élevée.

Un autre avantage de la diode active selon l'invention est que, dans les cas illustrés en figures 3 et 4, si jamais il se produit une inversion de polarité de la source d'alimentation 3, un courant inverse très important passera dans la diode active et la diode parallèle source/drain du transistor MOS de puissance, et/ou dans le transistor bipolaire parasite. Il n'est pas possible de bloquer ce courant inverse car inévitablement le transistor bipolaire parasite se mettrait en fonctionnement. Il peut en résulter une destruction du composant. Par contre, selon la présente invention, en cas d'inversion de polarité, il est possible de bloquer le transistor 50 et aucun transistor bipolaire parasite ne prendra le relais.

Bien entendu, la présente invention est susceptible de nombreuses variantes et modifications qui apparaîtront à l'homme de l'art. Notamment, un circuit particulier de commande du transistor 50 a été décrit dans le cadre du transistor MOS composite selon l'invention. L'homme de l'art notera que des composants autres qu'un comparateur et un inverseur pourraient être utilisés.

Egalement, au cas où l'on souhaite bloquer le transistor 50 selon la présente invention, pour arrêter le courant de roue libre, si le transistor 50 fonctionne en tout-ou-rien, on peut prévoir en parallèle sur ce transistor une diode à seuil.

En outre, on notera que l'existence d'un transistor bipolaire parasite, tel que le transistor 35 décrit précédemment, n'est pas spécifique de la technologie de réalisation de transistor MOS de puissance exposée en relation avec la figure 2, à savoir une technologie de transistor MOS diffusé vertical. Le même problème apparaît dans d'autres structures, par exemple dans des structures dites de transistor MOS de puissance semi-vertical, dans lesquels la zone N+ au lieu de constituer la face arrière d'un composant constitue un caisson enfermant la zone du transistor de puissance, ce caisson étant lui-même formé dans une zone de type P.

Enfin, dans tout ce qui précède, on a considéré le cas où tous les transistors MOS étaient des transistors MOS enrichis à canal N. La présente invention s'appliquerait aussi dans le cas où certains ou tous les transistors MOS seraient de type différent en modifiant de façon appropriée les polarités appliquées.

## Revendications

1. Transistor MOS composite (50) réalisé dans un substrat d'un premier type de conductivité comprenant une électrode de grille (G1), une première électrode principale (A1), une deuxième électrode principale (A2), une zone de substrat (60), et des moyens (51) pour connecter à la zone de substrat celle des première et deuxième électrodes principales qui est au plus faible potentiel.

2. Transistor MOS composite selon la revendication 1, réalisé dans un substrat d'un premier type de conductivité, caractérisé en ce que :
les première (A1) et deuxième (A2) électrodes principales sont respectivement connectées à une première borne principale d'un premier (52) et d'un deuxième (53) transistor MOS auxiliaire dont les deuxièmes bornes principales sont reliées au substrat,
les grilles (g2, g3) des premier et deuxième transistors auxiliaires sont commandées de façon complémentaire par la sortie d'un comparateur de tension (54) dont les entrées sont connectées aux électrodes principales dudit transistor composite (50),
d'où il résulte que l'électrode principale dudit transistor composite qui est au potentiel le plus faible est automatiquement reliée au substrat.

3. Transistor MOS selon la revendication 1, dans lequel lesdites électrodes principales correspondent à des diffusions du deuxième type de conductivité (61, 62) dans un caisson (60) du premier type de conductivité, caractérisé en ce que les deuxièmes bornes principales (63, 66) des transistors auxiliaires sont reliées à des diffusions (65, 68) du premier type de conductivité et à haut niveau de dopage formées dans ledit substrat (60).

4. Diode roue libre réalisée de façon monolithique dans un substrat comportant un transistor de puissance vertical (12), un transistor composite selon l'une quelconque des revendications 1 à 3, formé dans un caisson (60) de type de conductivité opposé à celui du substrat la première électrode principale (A1) dudit transistor (50) étant reliée à la borne de source du transistor de puissance (12) à laquelle est normalement reliée la première borne d'une charge externe (2), la deuxième électrode principale (A2) dudit transistor (50) étant reliée à une borne d'accès prévue pour être reliée à la deuxième borne de la charge, et la grille (G1) dudit transistor (50) étant commandée en opposition de phase avec la grille du transistor de puissance.

## Patentansprüche

1. MOS-Transistoranordnung (50), die auf einem Substrat eines ersten Leitungtyps realisiert ist, mit einer Steuerelektrode (G1), einer ersten Hauptelektrode (A1), einer zweiten Hauptelektrode (A2), einer Substratzone (60) und mit Mitteln (51), um mit der Substratzone diejenige der ersten und zweiten Hauptelektrode zu verbinden, welche auf einem niedrigeren Potential ist.

2. MOS-Transistoranordnung nach Anspruch 1, die auf einem Substrat eines ersten Leitungstyps realisiert ist, dadurch gekennzeichnet, daß:
die erste (A1) und zweite (A2) Hauptelektrode jeweils mit einem ersten Hauptanschluß eines ersten (52) bzw. eines zweiten (53) MOS-Hilfstransistors verbunden ist, deren zweite Hauptanschlüsse mit dem Substrat verbunden sind,
die Steuerelektroden (G2, G3) des ersten und zweiten Hilfstransistors in komplementärer Art über den Ausgang eines Spannungskomparators (54) angesteuert werden, dessen Eingänge mit den Hauptelektroden der Transistoranordnung (50) verbunden sind,
woraus resultiert, daß die Hauptelektrode der Transistoranordnung, die auf dem niedrigeren Potential ist, automatisch mit dem Substrat verbunden ist.

3. MOS-Transistor nach Anspruch 1, bei dem die Hauptelektroden Diffusionszonen des zweiten Leitungstyps (61, 62) in einem Graben (60) des ersten Leitungstyps entsprechen, dadurch gekennzeichnet, daß die zweiten Hauptanschlüsse (63, 66) der Hilfstransistoren mit Diffusionszonen (65, 68) des ersten Leitungstyps verbunden und mit einem hohen Dotierungsniveau in dem Substrat (60) gebildet sind.

4. Freilaufdiode, die nach monolithischer Art in einem Substrat gebildet ist, welches einen vertikalen Leistungstransistor (12) und eine Transistoranordnung nach einem der Ansprüche 1 bis 3 aufweist, die in einem Graben (60) eines dem Substrat entgegengesetzten Leitungstyps ausgebildet ist, wobei die erste Hauptelektrode (A1) des Transistors (50) mit dem Source-Anschluß des Leistungstransistors (12) verbunden ist, mit dem normalerweise der erste Anschluß einer externen Last (2) verbunden ist, wobei die zweite Hauptelektrode (A2) des Transistors (50) mit einem Zugriffsanschluß verbunden ist, der vorgesehen ist, um mit dem zweiten Anschluß der Last verbunden zu werden, und wobei die Steuerelektrode (G1) des Transistors (50) in Gegenphase mit der Steuerelektrode des Leistungstransistors angesteuert wird.

## Claims

1. A composite MOS transistor (50) realized in a substrate of a first conductivity type comprising a gate electrode (G1), a first main electrode (A1), a second main electrode (A2), a substrate area (60), and means (51) for connecting to the substrate area the one of the first and second main electrodes having the lowest potential.

2. A composite MOS transistor according to claim 1, realized in a substrate of the first conductivity type, wherein
- the first (A1) and second (A2) main electrodes of said composite MOS transistor are respectively connected to a first main terminal of a first (52) and second (53) auxiliary MOS transistor, the second main terminals of which are connected to the substrate,
- the gates (g2, g3) of said first and second auxiliary transistors are additionally controlled by the output of a voltage comparator (54), the inputs of which are connected to the main electrodes of said composite transistor (50),
whereby the main electrode of said composite transistor which is at the lowest potential is automatically connected to the substrate.

3. A composite MOS transistor according to claim 1, wherein said main electrodes correspond to diffusions of the second conductivity type (61, 62) in a well (60) of the first conductivity type, and wherein the second main terminals (63, 66) of said auxiliary transistors are connected to diffusions (65, 68) of said first conductivity type and having a high doping level, those diffusions being formed in said substrate (60).

4. A free-wheel diode realized in the monolithic form in a substrate including a vertical power transistor (12), a composite transistor according to any of claims 1 to 3 formed in a well (60) of a conductivity type opposite to that of the substrate, the first main electrode (A1) of said transistor (50) being connected to the source terminal of the power transistor (12) to which is usually connected the first terminal of an external load (2), the second main electrode (A2) of said transistor (12) to which is usually connected the first terminal of an external load (2), the second main electrode (A2) of said transistor (50) being connected to an access terminal provided for being connected to the second terminal of the load, and the gate (G1) of said transistor (50) being controlled in phase opposition with respect to the gate of the power transistor.
